(19) **Europäisches Patentamt European Patent Office Office européen des brevets**

(11) **EP 4 734 181 A1**

(12) **EUROPEAN PATENT APPLICATION**
published in accordance with Art. 153(4) EPC

(43) Date of publication:
**29.04.2026 Bulletin 2026/18**

(21) Application number: **24849492.4**

(22) Date of filing: **25.07.2024**

(51) International Patent Classification (IPC):
$H01M\ 4/505^{(2010.01)}$   $H01M\ 4/36^{(2006.01)}$
$C30B\ 29/22^{(2006.01)}$   $C01G\ 53/00^{(2025.01)}$
$H01M\ 10/052^{(2010.01)}$   $H01M\ 4/131^{(2010.01)}$
$H01M\ 4/1391^{(2010.01)}$   $H01M\ 4/02^{(2006.01)}$

(52) Cooperative Patent Classification (CPC):
**C01G 53/00; C30B 29/22; H01M 4/02; H01M 4/131; H01M 4/1391; H01M 4/36; H01M 4/505; H01M 4/525; H01M 10/052;** Y02E 60/10

(86) International application number:
**PCT/KR2024/010876**

(87) International publication number:
**WO 2025/028923 (06.02.2025 Gazette 2025/06)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **01.08.2023  KR 20230100308**

(71) Applicant: **LG Chem, Ltd.
Seoul 07336 (KR)**

(72) Inventors:
• **KIM, Dong Hwan
  Daejeon 34122 (KR)**

• **KO, Young Min
  Daejeon 34122 (KR)**
• **JUN, Tae Hwan
  Daejeon 34122 (KR)**
• **KIM, Jin Sol
  Daejeon 34122 (KR)**
• **OH, Myoung Hwan
  Daejeon 34122 (KR)**

(74) Representative: **Hoffmann Eitle
Patent- und Rechtsanwälte PartmbB
Arabellastraße 30
81925 München (DE)**

(54) **POSITIVE ELECTRODE ACTIVE MATERIAL, METHOD FOR MANUFACTURING SAME, AND POSITIVE ELECTRODE AND LITHIUM SECONDARY BATTERY COMPRISING SAME**

(57)    The present invention relates to a positive electrode active material, a method for manufacturing same, and a positive electrode and a lithium secondary battery comprising same, wherein the positive electrode active material comprises a lithium-rich manganese-based oxide which comprises a $Li_2MnO_3$ phase and a $LiMO_2$ phase (where M is an element comprising at least one selected from Ni, Co, and Mn), wherein the lithium-rich manganese-based oxide is in the form of a single particle and has a single crystallinity ($\chi$) of between 0.51 and 0.70 according to formula 1 described in the present specification.

[FIG. 1]

EP 4 734 181 A1

## Description

## TECHNICAL FIELD

### Cross-reference to Related Applications

This application claims the benefit of Korean Patent Application No. 10-2023-0100308, filed on August 01, 2023, in the Korean Intellectual Property Office, the contents of which are incorporated herein by reference.

### Technical Field

The present invention relates to a positive electrode active material, a method for preparing the same, and a positive electrode and a lithium secondary battery comprising the same.

## BACKGROUND ART

Lithium secondary batteries are composed of four major components of a positive electrode, a negative electrode, a separator and an electrolyte. Among them, a positive electrode active material included in the positive electrode plays a major role in determining capacity, output, and lifespan of a battery. In order for lithium secondary batteries to have high energy density, output and lifespan, it is essential to improve the performance of the positive electrode active material, and for this reason, much research has been conducted recently to develop high-performance positive electrode active materials.

A lithium-rich oxide (Li-rich layered oxide), a type of positive electrode active material, is a mixed phase of a $Li_2MnO_3$ phase and a $LiMO_2$ (wherein M is an element including at least one selected from Ni, Co and Mn) phase, and has the characteristics of providing a very large capacity of 250 mAh/g at high operating voltages (>3.5 V vs. Li/Li$^+$). Therefore, the lithium-rich oxide is attracting attention as a low-cost, high-capacity positive electrode active material.

However, the lithium-rich oxide is in the form of secondary particles in which primary particles having a fine average particle diameter ($D_{50}$) are aggregated, and thus has a large specific surface area and low particle strength. Therefore, if an electrode is manufactured using a positive electrode active material including secondary particles in which the primary particles are agglomerated, and then rolled, there is a problem in that particle breakage is severe and, if a cell is operated, a large amount of gas is generated, resulting in poor stability and life characteristics.

Therefore, it is necessary to secure technology improving the stability, life characteristics, and capacity characteristics of the lithium-rich oxide.

[Prior Art Document]

[Patent Document]

(Patent Document 1) Korean Laid-open Patent Publication No. 10-2016-0080865

## DISCLOSURE OF THE INVENTION

## TECHNICAL PROBLEM

The present invention is intended to solve the above problems and to provide a positive electrode active material that may improve the life characteristics and capacity characteristics of a battery, and a method for manufacturing the same.

In addition, the present invention provides a positive electrode and a secondary battery having excellent life characteristics and capacity characteristics by including the positive electrode active material above.

## TECHNICAL SOLUTION

In order to solve the tasks, the present invention provides a positive electrode active material, a method for preparing the same, and a positive electrode and a lithium secondary battery comprising the same.

(1) The present invention provides a positive electrode active material comprising: a lithium-rich manganese-based oxide comprising a $Li_2MnO_3$ phase and a $LiMO_2$ (where M is an element comprising one or more selected from Ni, Co and Mn) phase, wherein the lithium-rich manganese-based oxide has a single particle form, and the lithium-rich manganese-based oxide has a single crystallinity ($\chi$) of 0.51 to 0.70 according to Equation 1 below.

[Equation 1]

$$\chi = \sum_{i} a_i^2$$

In Equation 1, $a_i$ means a value ($A_i/A$) of a cross-sectional area ($A_i$) of an i-th crystal grain relative to a cross-sectional area ($A$) of a single particle in a case where the single particle is composed of i crystal grains.

(2) The present invention is the positive electrode active material according to (1), wherein the lithium-rich manganese-based oxide is represented by Formula 1 below.

[Formula 1]    $Li_xNi_aMn_bM^1_cO_2$

In Formula 1, $M^1$ is one or more selected from the group consisting of Co, Al, Zr, B, W, Mo, Cr, Nb, Mg, Hf, Ta, La, Ti, Sr, Ba, Ce, Sn, Y and Zn, $1.00 < x \leq 1.30$, $0.10 \leq a \leq 0.50$, $0.50 \leq b \leq 0.90$, $0 \leq c \leq 0.10$, and $x+a+b+c = 2$.

(3) The present invention provides the positive electrode active material according to (1) or (2), wherein an average particle diameter ($D_{50}$) of the lithium-rich manganese-based oxide is 0.6 $\mu$m to 1.5 $\mu$m.

(4) The present invention provides the positive electrode active material according to any one of (1) to (3), wherein a BET specific surface area of the lithium-rich manganese-based oxide is 1.5 $m^2$/g to 3.0 $m^2$/g.

(5) The present invention provides the positive electrode active material according to any one of (1) to (4), further comprising a coating layer that is formed on the lithium-rich manganese-based oxide and comprises one or more coating elements selected from the group consisting of Al, Ti, W, B, F, P, Mg, Ni, Co, Fe, Cr, V, Cu, Ca, Zn, Zr, Nb, Sr, Sb, Bi, Si and S.

(6) The present invention provides a method for preparing the positive electrode active material according to claim 1, the method comprising: (S10) a step of injecting a lithium (Li)-containing raw material, a nickel (Ni) - containing raw material and a manganese (Mn)-containing raw material to a pulverizing device, dry mixing and pulverizing to prepare a mixture; (S20) a step of sintering the mixture at a temperature of greater than 900°C to 1,100°C or less to prepare a sintered product; and (S30) a step of disintegrating the sintered product to obtain a positive electrode active material comprising a lithium-rich manganese-based oxide, wherein the pulverizing device comprises a chamber and a rotor rotatable within the chamber, and the mixing and pulverizing in step (S10) is performed by injecting the lithium (Li)-containing raw material, the nickel (Ni)-containing raw material, the manganese (Mn)-containing raw material, and beads to the chamber of the pulverizing device and rotating the rotor.

(7) The present invention provides the method for preparing the positive electrode active material according to (6), wherein the sintering in step (S20) is performed for 6 hours to 15 hours.

(8) The present invention provides the method for preparing the positive electrode active material according to (6) or (7), further comprising: after disintegrating the sintered product in step (S30), a step of mixing the lithium-rich manganese-based oxide and a coating raw material and heating to form a coating layer on the lithium-rich manganese-based oxide, wherein the heating is performed under a temperature of 300°C to 600°C.

(9) The present invention provides a positive electrode comprising the positive electrode active material according to any one of (1) to (5).

(10) The present invention provides a lithium secondary battery comprising the positive electrode according to (9).

**ADVANTAGEOUS EFFECTS**

The positive electrode active material according to the present invention is in the form of single particles, has a single crystallinity within a specific range, and includes a lithium-rich manganese-based oxide including a $Li_2MnO_3$ phase and a $LiMO_2$ (wherein M is an element including at least one selected from Ni, Co and Mn) phase, so that if the positive electrode active material is rolled for electrode manufacture, the generation of fine particles due to particle breakage may be prevented, and if applied to a battery, the generation of gas may be suppressed. Accordingly, the performance of a positive electrode and a secondary battery including the positive electrode active material, particularly, charge/discharge characteristics and life characteristics may be improved.

In addition, according to the method for preparing a positive electrode active material of the present invention, the positive electrode active material described above may be effectively prepared.

## BRIED DESCRIPTION OF DRAWINGS

FIG. 1 illustrates XRD data for the positive electrode active materials prepared in Example 1, Example 2, and Comparative Examples 1 to 4.

FIG. 2 illustrates SEM images of the positive electrode active materials prepared in Examples 1 to 3 and Comparative Examples 1, 3 and 4.

FIG. 3 illustrates an IPF map, a boundary image, and a segmentation image, obtained by EBSD analysis of a positive electrode for EBSD analysis, manufactured using each of the positive electrode active materials prepared in Examples 1 to 3 and Comparative Example 1.

FIG. 4 illustrates a schematic diagram of a pulverizing device for performing the method for preparing a positive electrode active material of the present invention.

FIG. 5 illustrates a schematic diagram of a pulverizing device for performing the method for preparing a positive electrode active material of the present invention.

FIG. 6 illustrates images of the surfaces of positive electrodes including the positive electrode active materials prepared in Examples 1 to 3, Comparative Example 3, and Comparative Example 4.

## BEST MODE FOR CARRYING OUT THE INVENTION

Hereinafter, the present invention will be explained in more detail to assist the understanding of the present invention.

Words or terms used in the present description and claims shall not be interpreted as the meaning defined in commonly used dictionaries. The words or terms should be interpreted as having a meaning that is consistent with the technical idea of the invention, based on the principle that an inventor may properly define the meaning of the words or terms to best explain the invention.

In the present description, the terms "comprise," "be provided with," or "have" are to be understood as specifying the presence of a feature, number, step, component, or combination thereof implemented, but not excluding in advance the possibility of the presence or addition of one or more other features, numbers, steps, components, or combinations thereof.

In the present description, a single particle form includes both a single particle form of a positive electrode active material and/or a lithium-rich manganese-based oxide and a form in which 2 to 10 particles are agglomerated. That is, the particles of the positive electrode active material and/or the lithium-rich manganese-based oxide of the present invention may include the single particle form of the positive electrode active material and/or the single particle form of the lithium-rich manganese-based oxide, as at least one selected from the group consisting of single particles and agglomerated particles of 2 to 10 particles.

In the present description, a "primary particle" refers to the smallest particle unit recognized by observing a positive electrode active material using a scanning electron microscope (SEM), and a "secondary particle" refers to a secondary structure formed by the agglomeration of multiple primary particles.

In the present description, a "single crystal" refers to a crystal that does not contain a grain boundary within the particle.

In the present description, a "crystal grain" means a particle unit having substantially the same crystal orientation, which may be measured by Electron Backscatter Diffraction (EBSD). Specifically, the crystal grain is the smallest particle unit exhibiting in the same color in an IPF map obtained by analyzing the cross-section of the positive electrode active material cut through ion milling using EBSD.

In the present description, the content of each element in the lithium-rich manganese-based oxide may be measured through inductive coupled plasma (ICP) analysis using an inductively coupled plasma optical emission spectrometer (ICP-OES; Optima 7300DV, PerkinElmer Co.).

In the present description, an average particle diameter ($D_{50}$) may be defined as a particle diameter of each particle, corresponding to 50% of an accumulated volume distribution on a particle size distribution curve (graph curve of particle size distribution). The average particle diameter may be measured by dispersing a target powder for measurement in a dispersion medium, introducing into a commercially available laser diffraction particle size measuring device (e.g., S3500 from Microtrac Co.), measuring a difference in diffraction patterns according to a particle size during the particles pass through a laser beam, calculating particle size distribution, and calculating a particle diameter at a point where 50% of volume cumulative distribution according to particle diameter in the measuring device to measure $D_{50}$.

In the present description, a "rotor" refers to one or more rotating blades attached to a rotating shaft (rotor center). The number, shape, size, and angle of each blade of the rotating blades may be changed, and a rotational force may be adjusted.

## Positive Electrode Active Material

Hereinafter, a positive electrode active material according to the present invention will be explained.

The positive electrode active material according to the present invention comprises a lithium-rich manganese-based oxide comprising a $Li_2MnO_3$ phase and a $LiMO_2$ (where M is an element comprising one or more selected from Ni, Co and Mn) phase, wherein the lithium-rich manganese-based oxide has a single particle form, and the lithium-rich manganese-based oxide has a single crystallinity ($\chi$) of 0.51 to 0.70 according to Equation 1 below.

$$[\text{Equation 1}]$$

$$\chi = \sum_i a_i^2$$

In Equation 1,

$a_i$ means a value ($A_i/A$) of a cross-sectional area ($A_i$) of an i-th crystal grain relative to a cross-sectional area (A) of a single particle in a case where the single particle is composed of i crystal grains.

Meanwhile, if the positive electrode active material does not include a lithium-rich manganese-based oxide, or if the lithium-rich manganese-based oxide does not include a $Li_2MnO_3$ phase and a $LiMO_2$ (wherein M is an element including at least one selected from Ni, Co and Mn) phase, and if is not a single particle and has a single crystallinity of less than 0.51, there is a problem in that fine particles are generated due to particle breakage in a case where a positive electrode active material is rolled for electrode manufacturing, and if the electrode thus manufactured is applied to a battery, there are problems in that capacity characteristics are inferior, gas is generated, and the life characteristics of the battery are deteriorated.

The inventors of the present invention have conducted repeated studies to solve the above problems and have found that, in a case of a positive electrode active material including a lithium-rich manganese-based oxide including a $Li_2MnO_3$ phase and a $LiMO_2$ (wherein M is an element including at least one selected from Ni, Co and Mn) phase and having a single particle form and a single crystallinity within a specific range, the grain boundary area of the particle surface may be minimized to improve thermal stability, the positive electrode active material may be suppressed from breakage during rolling for the manufacture of an electrode, and if applied to a battery, unnecessary side reactions with an electrolyte and gas generation amount may be improved, and capacity characteristics may be improved, thereby completing the present invention. As described above, a battery using the positive electrode active material according to the present invention may have small volume changes due to charge and discharge, and excellent life characteristics and capacity characteristics.

The lithium-rich manganese-based oxide includes a $Li_2MnO_3$ phase and a $LiMO_2$ (wherein M is an element including at least one selected from Ni, Co and Mn) phase. The lithium-rich manganese-based oxide according to the present invention does not include a $LiMn_2O_4$ phase. That is, the lithium-rich manganese-based oxide, as known in the art, does not include a $LiMn_2O_4$ phase, and is different from a lithium manganese oxide having a spinel structure and a composition of $LiMn_2O_4$.

The lithium-rich manganese-based oxide has a single particle form. That is, the lithium-rich manganese-based oxide may be single particles or have a single particle form in which 2 to 10 particles are agglomerated. The single particle form is distinguished from a secondary particle in which more than 10 primary particles are agglomerated. If the lithium-rich manganese-based oxide has a single particle form, stability is excellent, so that even if a positive electrode active material including the same is rolled, the positive electrode active material does not undergo breakage or cracking. Accordingly, the charge/discharge efficiency of the positive electrode active material may be improved, and side reactions between the positive electrode active material and an electrolyte may be reduced. As a result, durability against volume change during the charge/discharge of a battery applying the same may be improved, and high-temperature performance may be improved.

In the present invention, the single crystallinity is evaluated and expressed as a parameter represented by Equation 1 above. The single crystallinity in the present invention is a value that is adjusted according to the cross-sectional area of a single particle, the number of crystal grains forming one single particle, and the cross-sectional area of each crystal grain. The larger the cross-sectional area of a specific crystal grain having the largest cross-sectional area in one single particle, the higher the single crystallinity is if the specific crystal grain has a large area close to the cross-sectional area of the entire single particle.

That is, the single crystallinity shown in the present invention may be higher as the number of crystal grains forming a single particle is smaller, and if the number of crystal grains is the same, the single crystallinity is higher if the specific crystal grain has a larger cross-sectional area than other crystal grains, and a difference from the cross-sectional area of the entire single particle is small, rather than a case where the cross-sectional areas of the crystal grains are similar.

For example, the maximum value of the single crystallinity is 1, which means that one single particle is composed of one crystal grain. In addition, if one single particle is composed of N crystal grains, the single crystallinity varies depending on the cross-sectional area of each crystal grain, but, if there are N crystal grains, the minimum value of the single crystallinity is 1/N, which means that all N crystal grains have the same cross-sectional area. Even if one single particle is composed of N crystal grains, if a specific crystal grain has a larger cross-sectional area than other crystal grains, the single crystallinity is higher than 1/N, because the shape is closer to a single crystal if the specific crystal grain has the largest cross-sectional area compared to a case where N crystal grains have the same area.

From this point of view, if the cross-sectional area of an added crystal grain decreases, the single crystallinity decreases to a small degree, and since the cross-sectional area of the small-sized crystal grain is smaller than the cross-sectional area of the total particles, the effect of the small-sized crystal grain on the decrease in the single crystallinity is small.

The lithium-rich manganese-based oxide has a single crystallinity ($\chi$) of 0.51 to 0.70. Specifically, the single crystallinity of the lithium-rich manganese-based oxide may be 0.51 or more, 0.52 or more, 0.53 or more, 0.54 or more, 0.55 or more, 0.56 or more, 0.57 or more, 0.58 or more, 0.59 or more, 0.6 or more, 0.61 or more, or 0.62 or more, and may be 0.68 or less, 0.69 or less, or 0.70 or less. Specifically, if the single crystallinity ($\chi$) is 0.62 to 0.68, it can be found that in the lithium-rich manganese-based oxide of the present invention, a specific crystal grain having the largest cross-sectional area within a single particle has a cross-sectional area close to about half of the cross-sectional area of the entire single particle. Accordingly, if rolling for electrode manufacturing or operating a cell, particle breakage due to grain boundaries may be suppressed, the grain boundary area in contact with an electrolyte may be reduced, and gas generation due to side reactions with the electrolyte may be reduced, so that the lifespan of a secondary battery may be significantly improved. Meanwhile, if the single crystallinity is less than 0.51, particle breakage due to grain boundaries occurs during rolling for electrode manufacturing or operating a cell, and the grain boundary area in contact with the electrolyte is significantly increased, so that the amount of gas generation due to side reactions with the electrolyte increases and the charge/-discharge efficiency decreases. If the single crystallinity is greater than 0.70, there is a problem of inferior capacity characteristics. Specifically, if a lithium-rich manganese-based oxide is prepared so as to have the single crystallinity of greater than 0.70, since the specific surface area is greatly increased due to the heating at a high temperature, the reaction area is greatly reduced, and there is a problem of inferior capacity characteristics.

According to an embodiment of the present invention, the lithium-rich manganese-based oxide may be represented by Formula 1 below.

[Formula 1]     $Li_xNi_aMn_bM^1_cO_2$

In Formula 1,

$M^1$ is one or more selected from the group consisting of Co, Al, Zr, B, W, Mo, Cr, Nb, Mg, Hf, Ta, La, Ti, Sr, Ba, Ce, Sn, Y and Zn,
$1.00 < x \leq 1.30$, $0.10 \leq a \leq 0.50$, $0.50 \leq b \leq 0.90$, $0 \leq c \leq 0.10$, and $x+a+b+c = 2$.
$M^1$ is a doping element, and specifically, $M^1$ may be one or more selected from the group consisting of Co, Al, Zr, B, W, Mo, Cr, Nb, Mg, Hf, Ta, La, Ti, Sr, Ba, Ce, Sn, Y, and Zn. $M^1$ is not necessarily included, but if included in an appropriate amount, may improve the crystal structure stability of a positive electrode active material and/or the charge/discharge characteristics of a secondary battery manufactured therefrom.

Meanwhile, x may be greater than 1.00, 1.05 or more, 1.10 or more, or 1.15 or more, and 1.20 or less, 1.25 or less, or 1.30 or less. If x satisfies the above range, high capacity characteristics and high energy density per unit volume may be achieved.

a may be 0.10 or more, 0.15 or more, or 0.20 or more, and may be 0.25 or less, 0.30 or less, 0.35 or less, 0.40 or less, 0.45 or less, or 0.50 or less. If a satisfies the above range, the initial charge/discharge capacity of a secondary battery may be improved at voltages of 4.4 V or less.

b may be 0.50 or more, 0.55 or more, or 0.60 or more, and may be 0.75 or less, 0.80 or less, 0.85 or less, or 0.90 or less. If b satisfies the above range, the initial charge/discharge capacity of a secondary battery may be improved at voltages of 4.4 V or more.

c may be 0 or more, 0.03 or more, 0.04 or more, or 0.05 or more, and may be 0.08 or less, 0.09 or less, or 0.10 or less. If c satisfies the above range, the crystal structure stability of a positive electrode active material and/or the charge/-discharge characteristics of a secondary battery manufactured therefrom may be improved.

In Formula 1, x, a, b, and c may satisfy $x+a+b+c = 2$.

In addition, according to an embodiment of the present invention, the average particle diameter ($D_{50}$) of the

lithium-rich manganese-based oxide may be 0.6 $\mu$m to 1.5 $\mu$m. The average particle diameter of the lithium-rich manganese-based oxide may be specifically, 0.6 $\mu$m or more, 0.7 $\mu$m or more, or 0.8 $\mu$m or more, and 1.3 $\mu$m or less, 1.4 $\mu$m or less, or 1.5 $\mu$m or less. If the average particle diameter ($D_{50}$) satisfies the above range, particle breakage may be suppressed compared to common secondary particles in which primary particles are agglomerated, and side reactions with an electrolyte and a gas generation amount may be reduced, thereby improving life characteristics. In addition, capacity reduction and performance degradation due to a decrease in rolling density may be prevented, and output characteristics may be improved by suppressing an increase in resistance.

In addition, according to an embodiment of the present invention, the BET specific surface area of the lithium-rich manganese-based oxide may be 1.5 $m^2$/g to 3.0 $m^2$/g. Specifically, the lithium-rich manganese-based oxide may have a BET specific surface area of 1.5 $m^2$/g or more, 1.6 $m^2$/g or more, or 1.7 $m^2$/g or more, and 2.4 $m^2$/g or less, 2.7 $m^2$/g or less, or 3.0 $m^2$/g or less.

The higher the single crystallinity of the particle, the smaller the grain boundary area of the particle surface, which may result in a small BET specific surface area. Therefore, it can be found that the single crystallinity is relatively high through the BET specific surface area satisfying the above range. If the BET specific surface area satisfies the above range, side reactions with an electrolyte and a gas generation amount during charge/discharge processes may be reduced, which may improve life characteristics.

In addition, according to an embodiment of the present invention, a coating layer formed on the lithium-rich manganese-based oxide and including one or more coating elements selected from the group consisting of Al, Ti, W, B, F, P, Mg, Ni, Co, Fe, Cr, V, Cu, Ca, Zn, Zr, Nb, Sr, Sb, Bi, Si and S, may be further included. By suppressing side reactions with an electrolyte by the coating layer, life characteristics may be further improved. Specifically, the coating element may include one or more elements selected from the group consisting of Al, W, V and B.

## Method for Preparing Positive Electrode Active Material

Then, a method for preparing a positive electrode active material of the present invention will be described. The method for preparing a positive electrode active material of the present invention is a method for preparing the positive electrode active material according to the present invention.

A method for preparing a positive electrode active material according to the present invention comprises: (S10) a step of injecting a lithium (Li)-containing raw material, a nickel (Ni)-containing raw material and a manganese (Mn)-containing raw material to a pulverizing device, dry mixing and pulverizing to prepare a mixture; (S20) a step of sintering the mixture at a temperature of greater than 900°C to 1,100°C or less to prepare a sintered product; and (S30) a step of disintegrating the sintered product to obtain a positive electrode active material comprising a lithium-rich manganese-based oxide, wherein the pulverizing device comprises a chamber and a rotor rotatable within the chamber, and the mixing and pulverizing in step (S10) is performed by injecting the lithium (Li)-containing raw material, the nickel (Ni)-containing raw material, the manganese (Mn)-containing raw material, and beads to the chamber of the pulverizing device and rotating the rotor.

The positive electrode active material according to the present invention described above may be prepared by appropriately controlling the type of raw materials, mixing ratio, sintering step, sintering temperature, sintering atmosphere or the like.

Hereinafter, each step of the present invention will be particularly explained.

## Step (S10)

The lithium-rich manganese-based oxide of the present invention uses a process of dry mixing solid raw materials, and since no medium is used, energy from beads is directly transferred to raw material particles, which is energy efficient, does not require medium filtration and a drying process and is simple. On the other hand, if a process of wet mixing a positive electrode active material precursor and a lithium-containing raw material to prepare a mixture is used, particle growth may not be smooth, single particles may not sufficiently propagate, and since an over-sintering process is required, capacity reduction may occur during battery use due to the formation of a rock-salt phase or the like. In addition, since a precursor-based secondary particle form coexists, the single crystallinity desired in the present invention may not be achieved.

In selecting raw materials for lithium (Li)-containing raw material, nickel (Ni)-containing raw material, and manganese (Mn)-containing raw material, any raw material applicable to a solid-phase synthesis method may be used without limitation. However, since residual sulfur after synthesis may cause problems in the positive electrode active material and sintering equipment, it is preferable to exclude a sulfate-based compound, and specifically, oxide, carbonate, and hydroxide-based compounds may be used.

For example, the lithium (Li)-containing raw material may be at least one selected from the group consisting of LiOH, $Li_2CO_3$, $LiNO_3$, $LiNO_2$, LiOH·$H_2O$, LiH, LiF, LiCl, LiBr, LiI, $CH_3COOLi$, $Li_2O$, Li acetate, Li dicarboxylate, Li citrate, Li fatty acid, alkyl lithium, and lithium halides, and one or a mixture of two or more thereof may be used. Specifically, in view of a melting point, LiOH may be used.

The nickel (Ni)-containing raw material may be at least one selected from the group consisting of NiO, Ni(OH)$_2$, NiOOH, NiCO$_3$·2Ni(OH)$_2$·4H$_2$O, NiC$_2$O$_4$·2H$_2$O, Ni(NO$_3$)$_2$·6H$_2$O, fatty acid nickel, and nickel halides, and one or a mixture of two or more thereof may be used. Specifically, the production of CO$_2$ and reaction with residual lithium during sintering may be prevented, and in view of a melting point, Ni(OH)$_2$ may be used.

The manganese (Mn)-containing raw material may be at least one selected from the group consisting of MnCO$_3$, Mn$_2$O$_3$, MnO$_2$, Mn$_3$O$_4$, Mn(NO$_3$)$_2$, manganese acetate, manganese dicarboxylate, manganese citrate, manganese salts of fatty acid, oxyhydroxides, and halides of manganese chloride, and one or a mixture of two or more thereof may be used. Specifically, MnO$_2$ may be used to prevent CO$_2$ from being generated during sintering and reacting with residual lithium.

According to the present invention, the lithium (Li)-containing raw material, the nickel (Ni)-containing raw material, and the manganese (Mn)-containing raw material may be mixed in amounts so as to have a composition represented by Formula 1 above.

The lithium-rich manganese-based oxide of the present invention utilizes a process of mixing and pulverizing using a rotor and beads. The pulverizing and mixing efficiency may be improved by using a rotor and beads compared to a ball mill, and pulverizing at a level equivalent to or higher than that of a ball mill is possible within several minutes to several hours.

In addition, since the raw material particles have a small size and are mixed uniformly through the mixing and pulverizing processes, the particle growth may be smooth during sintering, and excellent single crystallinity may be exhibited.

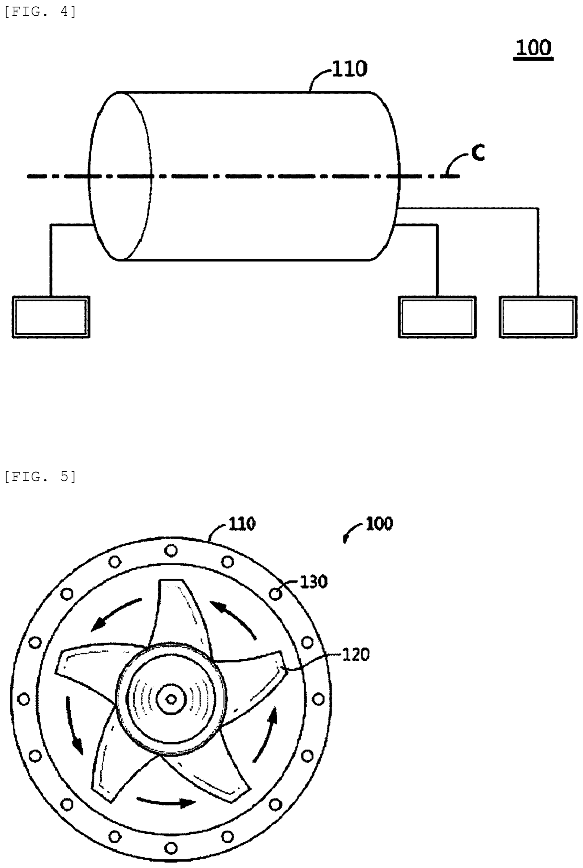

The pulverizing device that may be used in the above method for preparing the positive electrode active material is a pulverizing device shown in FIG. 4. FIG. 5 is a front view with a chamber in an open state of the pulverizing device shown in FIG. 4. A pulverizing device (100) has a cylindrical chamber (110) whose central axis (C) is horizontally positioned, and a rotor (120) capable of highspeed rotation is provided on the central axis inside. The rotation axis of the rotor (120) is horizontally positioned in line with the central axis of the chamber (110). Since the rotation axis of the rotor (120) is horizontal and the raw material particles rotate along the rotation axis, it may be called a horizontal mill. The rotating blade combined with the rotor (120) may have various shapes such as a plate shape, a trapezoid shape, and a spiral shape.

Meanwhile, if the pulverizing device is not a pulverizing device shown in FIG. 4, there is a problem in that a LiMn$_2$O$_4$ phase is formed in addition to a Li$_2$MnO$_3$ phase and a LiMO$_2$ (wherein M is an element including at least one selected from Ni, Co and Mn) phase during the preparation of the positive electrode active material. If the positive electrode active material includes a LiMn$_2$O$_4$ phase, there is a problem in that the capacity characteristics and life characteristics of a battery including the same are inferior.

**Step (S20)**

Then, a step of sintering the mixture to produce a sintered product is included.

The mixture may be sintered at a temperature greater than 900°C, 950°C or more, or 1,000°C or more, and 1,050°C or less, or 1,100°C or less. In the above temperature range, not only the formation of a secondary phase is suppressed, but also a lithium-rich manganese-based oxide in the form of a single particle and having a high single crystallinity is formed, thereby preventing the charge and discharge capacity of the positive electrode active material from being reduced and improving the life characteristics of a secondary battery manufactured therefrom. If sintering is performed at a temperature of 900°C or less, a positive electrode active material in the form of secondary particles is prepared, and there is a problem with the formation of a single particle form, and if sintering is performed at a temperature greater than 1,100°C, there is a problem with the electrochemical characteristics being reduced because a layered crystal structure is not properly formed due to over-sintering.

The sintering may be performed for 6 hours or more, 7 hours or more, 8 hours or more, 9 hours or more, 10 hours or more, or 11 hours or more, or 12 hours or less, 13 hours or less, 14 hours or less, or 15 hours or less. In the above time range, it is advantageous for the formation of a single particle form, and the particles may grow sufficiently.

**Step (S30)**

Then, a step of disintegrating the sintered product to obtain a positive electrode active material including a lithium-rich manganese-based oxide is included.

After disintegrating the sintered product, a step of mixing the lithium-rich manganese-based oxide and a coating raw material and heating to form a coating layer on the lithium-rich manganese-based oxide may be further included.

The coating layer may be formed using a method known in the art, for example, a wet coating method, a dry coating method, a plasma coating method, or an atomic layer deposition (ALD).

The wet coating method may be performed by, for example, adding the lithium-rich manganese-based oxide and the coating raw material to a suitable solvent such as ethanol, water, methanol and acetone, and then mixing until the solvent disappears.

The dry coating method is a method of mixing the lithium-rich manganese-based oxide and the coating raw material in a solid phase without a solvent, and for example, a grinder mixing method or a mechanofusion method may be used.

The coating raw material may be an oxide, a hydroxide, an oxyhydroxide, a carbonate, a sulfate, a halide, a sulfide, an acetate, a carboxylate or a combination thereof, including one or more elements (hereinafter referred to as "coating elements") selected from the group consisting of Al, Ti, W, B, F, P, Mg, Ni, Co, Fe, Cr, V, Cu, Ca, Zn, Zr, Nb, Sr, Sb, Bi, Si and S, for example, $ZnO$, $Al_2O_3$, $Al(OH)_3$, $AlSO_4$, $AlCl_3$, Al-isopropoxide, $AlNO_3$, $TiO_2$, $WO_3$, $AlF$, $H_2BO_3$, $HBO_2$, $H_3BO_3$, $H_2B_4O_7$, $B_2O_3$, $C_6H_5B(OH)_2$, $(C_6H_5O)_3B$, $(CH_3(CH_2)_3O)_3B$, $C_3H_9B_3O_6$, $(C_3H_7O_3)B$, $Li_3WO_4$, $(NH_4)_{10}W_{12}O_{41} \cdot 5H_2O$, $NH_4H_2PO_4$, or the like, but are not limited thereto.

After the coating raw material is attached to the lithium-rich manganese-based oxide through the above method, a coating layer may be formed through heat treatment. In this case, the heat treatment may be performed at a temperature of 300°C or higher, 350°C or higher, or 400°C or higher, and 450°C or lower, 500°C or lower, 550°C or lower, or 600°C or lower. In the above temperature range, a coating layer in the form of a lithium complex may be formed by the reaction of the coating raw material and the residual lithium on the surface, or a coating layer may be formed in the form of a coating raw material coated by melting the coating raw material, and a coating layer with an appropriate thickness may be formed on the lithium-rich manganese-based oxide.

**Positive Electrode**

Then, a positive electrode according to present invention will be explained.

The positive electrode according to the present invention includes a positive electrode active material layer including the positive electrode active material according to the present invention. Specifically, the positive electrode includes a positive electrode current collector and a positive electrode active material layer formed on the positive electrode current collector and includes the positive electrode active material. Since the positive electrode active material has been described above, a detailed description thereof will be omitted, and only the remaining components will be explained in detail below.

The positive electrode current collector is not particularly limited as long as it is conductive and does not cause chemical changes in a battery and may use, for example, stainless steel, aluminum, nickel, titanium, fired carbon, or aluminum or stainless steel, surface-treated with carbon, nickel, titanium, silver or the like. In addition, the positive electrode current collector may typically have a thickness of 3 $\mu$m to 500 $\mu$m, and fine unevenness may be formed on the surface of the current collector to increase the adhesive strength with the positive electrode active material. For example, the positive electrode current collector may be used in various forms such as a film, a sheet, a foil, a net, a porous body, a foam, and a non-woven fabric.

The positive electrode active material layer may include a conductive material and a binder together with the positive electrode active material. In this case, the positive electrode active material may be included in an amount of 80 wt% to 99 wt%, more specifically, 85 wt% to 98.5 wt% on the basis of the total weight of the positive electrode active material layer, and within this range, excellent capacity characteristics may be exhibited.

The conductive material is used to provide the electrode with conductivity, and may be used without specific limitations as long as it does not cause chemical changes in the battery to be formed and has electronic conductivity. Specific examples include: graphite such as natural graphite and artificial graphite; carbon-based materials such as carbon black, acetylene black, Ketjen black, channel black, furnace black, lamp black, thermal black and carbon fiber; metal powders or metal fibers of copper, nickel, aluminum, silver or the like; conductive whiskers of zinc oxide, potassium titanate or the like; conductive metal oxides such as titanium oxide; or conductive polymers such as polyphenylene derivatives, and one of them alone or a mixture of two or more thereof may be used. The conductive material may be included in 0.1 wt% to 15 wt% on the basis of the total weight of the positive electrode active material layer.

The binder serves to improve the adhesion among the positive electrode active material particles and the adhesion between the positive electrode active material and the current collector. Specific examples include polyvinylidene fluoride (PVDF), a vinylidene fluoride-hexafluoropropylene copolymer (PVDF-co-HFP), polyvinylalcohol, polyacrylonitrile, carboxymethyl cellulose (CMC), starch, hydroxypropyl cellulose, regenerated cellulose, polyvinyl pyrrolidone, tetrafluoroethylene, polyethylene, polypropylene, an ethylene-propylene-diene polymer (EPDM), a sulfonated-EPDM, styrene butadiene rubber (SBR), fluoro-rubber, or various copolymers thereof, and one of them alone or a mixture of two or more thereof may be used. The binder may be included in 0.1 wt% to 15 wt% on the basis of the total weight of the positive electrode active material layer.

The positive electrode may be manufactured according to a common method for manufacturing a positive electrode, except that the above positive electrode active material is used. Specifically, the positive electrode may be manufactured by applying a composition for forming a positive electrode active material layer prepared by dissolving or dispersing the positive electrode active material and optionally a binder and a conductive material in a solvent, onto a positive electrode current collector, followed by drying and rolling. In this case, the types and contents of the positive electrode active material, binder, and conductive material are the same as described above. In addition, as another method, the positive electrode may be manufactured by casting the composition for forming a positive electrode active material layer onto a separate support, and then laminating the film thus obtained by peeling it off from the support onto a positive electrode current collector.

The solvent may be a solvent commonly used in the relevant technical field, and may include dimethyl sulfoxide (DMSO), isopropyl alcohol, N-methylpyrrolidone (NMP), acetone, or water. One of them alone or a mixture of two or more thereof may be used. The amount of the solvent used is sufficient to dissolve or disperse the positive electrode active material, conductive material and binder, in consideration of the coating thickness and preparation yield of the slurry, and to have a viscosity that may exhibit excellent thickness uniformity if applied subsequently to manufacture a positive electrode.

**Lithium Secondary Battery**

Then, a lithium secondary battery according to the present invention will be explained.

The present invention may manufacture an electrochemical device including the positive electrode. The electrochemical device may be specifically a battery, a capacitor or the like, and more specifically, a lithium secondary battery.

The lithium secondary battery specifically includes a positive electrode, a negative electrode positioned opposite to the positive electrode, and a separator and an electrolyte interposed between the positive electrode and the negative electrode. Since the positive electrode is the same as described above, a detailed description will be omitted, and only the remaining components are particularly explained below.

In addition, the lithium secondary battery may optionally further include a battery container that accommodates an electrode assembly of the positive electrode, negative electrode, and separator, and a sealing member that seals the battery container.

In the lithium secondary battery, the negative electrode includes a negative electrode current collector and a negative electrode active material layer positioned on the negative electrode current collector.

The negative current collector is not particularly limited as long as it has high conductivity without causing chemical changes in the battery, and may use, for example, copper, stainless steel, aluminum, nickel, titanium, fired carbon, copper or stainless steel, surface-treated with carbon, nickel, titanium, silver or the like, an aluminum-cadmium alloy or the like. In addition, the negative current collector may typically have a thickness of 3 $\mu$m to 500 $\mu$m, and, like the positive current collector, fine unevenness may be formed on the surface of the current collector to reinforce the bonding strength with the negative electrode active material. For example, the negative current collector may be used in various forms such as a film, a sheet, a foil, a net, a porous body, a foam, and a non-woven fabric.

The negative electrode active material layer optionally includes a binder and a conductive material together with the negative electrode active material.

As the negative electrode active material, a compound capable of reversible intercalation and deintercalation of lithium may be used. Specific examples thereof include: carbonaceous materials such as artificial graphite, natural graphite, graphitized carbon fiber and amorphous carbon; metallic compounds capable of alloying with lithium, such as Si, Al, Sn, Pb, Zn, Bi, In, Mg, Ga, Cd, a Si alloy, a Sn alloy and an Al alloy; metallic oxides capable of doping and dedoping lithium, such as $SiO_\beta$ ($0<\beta<2$), $SnO_2$, vanadium oxide, and lithium vanadium oxide; or composites containing the metallic compounds and carbonaceous materials, such as Si-C composites or Sn-C composites, and any one or a mixture of two or more thereof may be used. In addition, a metallic lithium thin film may be used as the negative electrode active material. In addition, both low-crystalline carbon and high-crystalline carbon may be used as the carbon material. Representative examples of the low-crystalline carbon include soft carbon and hard carbon, and representative examples of high-crystalline carbon include amorphous, plate-like, flaky, spherical, fibrous natural graphite or artificial graphite, Kish graphite, pyrolytic carbon, mesophase pitch-based carbon fiber, mesocarbon microbeads, mesophase pitches, and high-temperature fired carbon such as petroleum or coal tar pitch derived cokes.

The negative electrode active material may be included in 80 wt% to 99 wt% on the basis of the total weight of the negative electrode active material layer.

The binder is a component that assists in bonding among the conductive material, the active material, and the current collector, and may be typically added in 0.1 wt% to 10 wt% on the basis of the total weight of the negative electrode active material layer. Examples of such binder include polyvinylidene fluoride (PVDF), polyvinyl alcohol, carboxymethyl cellulose (CMC), starch, hydroxypropyl cellulose, regenerated cellulose, polyvinyl pyrrolidone, tetrafluoroethylene, polyethylene, polypropylene, an ethylene-propylene-diene polymer (EPDM), a sulfonated-EPDM, styrene-butadiene rubber, nitrile-butadiene rubber, fluoro-rubber, and various copolymers thereof.

The conductive material is a component for further improving the conductivity of the negative electrode active material, and may be added in 10 wt% or less, particularly, 5 wt% or less on the basis of the total weight of the negative electrode active material layer. The conductive material is not particularly limited as long as it has conductivity without causing chemical changes in the battery, and for example, graphite such as natural graphite and artificial graphite; carbon black such as acetylene black, Ketjen black, channel black, furnace black, lamp black and thermal black; conductive fibers such as carbon fiber and metal fiber; fluorinated carbon, metal powders of aluminum, nickel or the like; conductive whiskers of zinc oxide, potassium titanate or the like; conductive metal oxides such as titanium oxide; and conductive materials such as polyphenylene derivatives may be used.

The negative electrode active material layer may be manufactured by applying a composition for forming a negative electrode active material layer, prepared by dissolving or dispersing a negative electrode active material, and optionally a binder and a conductive material in a solvent on a negative electrode current collector, and drying, or by casting the composition for forming a negative electrode active material layer on a separate support, and then laminating the film thus obtained by peeling it off from the support on the negative electrode current collector.

Meanwhile, in the lithium secondary battery, the separator separates the negative electrode and the positive electrode and provides a passage for lithium ions to move, and a separator that is used as a separator in a common lithium secondary battery may be used without any specific limitations, and particularly, a separator that has low resistance to ion movement of the electrolyte and excellent electrolyte impregnation ability may be preferable. Specifically, a porous polymer film, for example, a porous polymer film made of a polyolefin-based polymer such as an ethylene homopolymer, a propylene homopolymer, an ethylene/butene copolymer, an ethylene/hexene copolymer, and an ethylene/methacrylate copolymer, or a laminated structure of two or more thereof may be used. In addition, a common porous nonwoven fabric, for example, a nonwoven fabric made of high-melting-point glass fiber, polyethylene terephthalate fiber or the like may be used. In addition, a coated separator containing a ceramic component or a polymer material to secure heat resistance or mechanical strength may be used, and a single-layer or multi-layer structure may be optionally used.

In addition, the electrolyte used in the present invention may include, but is not limited thereto, an organic liquid electrolyte, an inorganic liquid electrolyte, a solid polymer electrolyte, a gel-type polymer electrolyte, a solid inorganic electrolyte, and a molten inorganic electrolyte, that may be used for the manufacture of a lithium secondary battery.

Particularly, the electrolyte may include an organic solvent and a lithium salt.

As the organic solvent, any solvent that may act as a medium through which ions involved in the electrochemical reaction of the battery may move, may be used without specific limitation. Specifically, the organic solvent may include: ester solvents such as methyl acetate, ethyl acetate, $\gamma$-butyrolactone and $\varepsilon$-caprolactone; ether solvents such as dibutyl ether and tetrahydrofuran; ketone solvents such as cyclohexanone; aromatic hydrocarbon solvents such as benzene and fluorobenzene; carbonate solvents such as dimethylcarbonate (DMC), diethylcarbonate (DEC), ethylmethylcarbonate (EMC), ethylenecarbonate (EC) and propylene carbonate (PC); alcohol solvents such as ethyl alcohol and isopropyl alcohol; nitriles such as R-CN (wherein R represents a linear, branched, or cyclic hydrocarbon group having 2 to 20 carbon atoms and may include a double-bonded aromatic ring or an ether bond); amides such as dimethylformamide; dioxolanes such as 1,3-dioxolane; and sulfolanes. Among them, a carbonate solvent is preferable, and a mixture of a cyclic carbonate having high ionic conductivity and high dielectric constant that may improve the charge and discharge performance of a battery (e.g., ethylene carbonate, propylene carbonate or the like) and a linear carbonate compound having low viscosity (e.g., ethyl methyl carbonate, dimethyl carbonate, diethyl carbonate or the like) is more preferable. In this case, if the cyclic carbonate and the chain carbonate are mixed and used in a volume ratio of about 1:1 to about 1:9, the performance of the electrolyte may be exhibited excellent.

The lithium salt may use without any specific limitations as long as it is a compound capable of providing lithium ions used in a lithium secondary battery. Specifically, the lithium salt may use $LiPF_6$, $LiClO_4$, $LiAsF_6$, $LiBF_4$, $LiSbF_6$, $LiAlO_4$, $LiAlCl_4$, $LiCF_3SO_3$, $LiC_4F_9SO_3$, $LiN(C_2F_5SO_3)_2$, $LiN(C_2F_5SO_2)_2$, $LiN(CF_3SO_2)_2$, $LiCl$, $LiI$, $LiB(C_2O_4)_2$ or the like. The concentration of the lithium salt used may be within a range of 0.1 to 5.0 M, particularly, 0.1 to 3.0 M. If the concentration of the lithium salt is within the above range, the electrolyte may have appropriate conductivity and viscosity, and may exhibit excellent electrolyte performance, and lithium ions may move effectively.

In addition to the electrolyte constituent components, the electrolyte may further include one or more additives, for example, haloalkylene carbonate compounds such as difluoroethylene carbonate, pyridine, triethylphosphite, triethanolamine, cyclic ethers, ethylene diamine, n-glyme, hexaphosphoric acid triamide, nitrobenzene derivatives, sulfur, quinone imine dyes, N-substituted oxazolidinones, N,N-substituted imidazolidines, ethylene glycol dialkyl ethers, ammonium salts, pyrrole, 2-methoxy ethanol, or aluminum trichloride, for the purpose of improving the life characteristics of a battery, suppressing the reduction in battery capacity, and improving the discharge capacity of a battery. In this case, the additives may be included in 0.1 to 10wt%, particularly, 0.1 to 5 wt% on the basis of the total weight of the electrolyte.

Since the lithium secondary battery including the positive electrode active material according to the present invention exhibits excellent life characteristics and capacity characteristics, it is useful in the fields of portable devices such as mobile phones, notebook computers and digital cameras, and electric vehicles such as hybrid electric vehicles (HEVs).

Accordingly, according to another embodiment of the present invention, a battery module including the lithium secondary battery as a unit cell and a battery pack including the same are provided.

The battery module or battery pack may be used as a power source for one or more medium- or large-sized devices including: power tools; electric cars including electric vehicles (EVs), hybrid electric vehicles and plug-in hybrid electric vehicles (PHEVs); or power storage systems.

There is no particular limitation on the external shape of the lithium secondary battery of the present invention, but it may be a cylindrical shape, a prismatic shape, a pouch shape, or a coin shape using a can.

The lithium secondary battery according to the present invention may be used not only as a battery cell used as a power source for small-sized devices, but may also preferably be used as a unit battery in medium- or large-sized battery modules including a plurality of battery cells.

Hereinafter, embodiments will be explained in detail to particularly explain the present invention. However, the embodiments of the present invention can be modified into various other types, and the scope of the present invention should not be interpreted to be limited to the embodiments below.

## MODE FOR CARRYING OUT THE INVENTION

### Examples

### Example 1

LiOH (103.99 g), Ni(OH)$_2$ (38.29 g), and MnO$_2$ (107.22 g) were added to the chamber of a pulverizing device equipped with a rotor in FIG. 5, and 2.0 kg of zirconia beads having a diameter of 5 mm were added to the chamber of the pulverizing device so that they take 40 vol% of the volume of the chamber of the pulverizing device. Thereafter, the rotor was rotated at 1,600 rpm for 30 minutes to perform mixing and pulverizing. 100 g of a raw material powder obtained through pulverizing and mixing was taken and placed in a crucible and sintered at 1,000°C for 12 hours in an air atmosphere to produce a sintered product. The sintered product was disintegrated and then classified to obtain a positive electrode active material (lithium-rich manganese-based oxide) powder having an average composition of Li$_{1.20}$Ni$_{0.20}$Mn$_{0.60}$O$_2$.

### Example 2

LiOH (103.60 g), Ni(OH)$_2$ (53.40 g), and MnO$_2$ (93.00 g) were added to the chamber of a pulverizing device equipped with a rotor in FIG. 5, and 2.0 kg of zirconia beads having a diameter of 5 mm were added to the chamber of the pulverizing device so that they take 40 vol% of the volume of the chamber of the pulverizing device. Thereafter, the rotor was rotated at 1,600 rpm for 30 minutes to perform mixing and pulverizing. 100 g of a raw material powder obtained through pulverizing and mixing was taken and placed in a crucible and sintered at 1,000°C for 12 hours in an air atmosphere to produce a sintered product. The sintered product was disintegrated and then classified to obtain a positive electrode active material (lithium-rich manganese-based oxide) powder having an average composition of Li$_{1.20}$Ni$_{0.28}$Mn$_{0.52}$O$_2$.

### Example 3

A positive electrode active material (lithium-rich manganese-based oxide) powder was obtained by performing the same method as in Example 1 except that 100 g of a raw material powder obtained through pulverizing and mixing was taken and placed in a crucible and sintered at 1,050°C for 12 hours in an air atmosphere to produce a sintered product.

### Comparative Example 1

A Ni$_{0.25}$Mn$_{0.73}$(OH)$_2$ precursor and LiOH·H$_2$O were mixed in a stirring mixer (Waring Co., 7011S) and sintered at 1,000°C for 12 hours in an air atmosphere to produce a positive electrode active material. The sintered product was disintegrated and then classified to obtain a positive electrode active material (lithium-rich manganese-based oxide) powder having an average composition of Li$_{1.20}$Ni$_{0.20}$Mn$_{0.60}$O$_2$.

### Comparative Example 2

LiOH (103.99 g), Ni(OH)$_2$ (38.29 g) and MnO$_2$ (107.22 g) were added to and mixed in a stirring mixer (Waring Co., 7011S). 100 g of a raw material powder obtained through mixing was taken and placed in a crucible and sintered at 1,000°C for 12 hours in an air atmosphere to produce a sintered product. The sintered product was disintegrated and then classified to obtain a positive electrode active material powder having an average composition of Li$_{1.20}$Ni$_{0.20}$Mn$_{0.60}$O$_2$.

**Comparative Example 3**

A positive electrode active material (lithium-rich manganese-based oxide) powder was obtained by performing the same method as in Example 1 except that 100 g of a raw material powder obtained through pulverizing and mixing was taken and placed in a crucible and sintered at 850°C for 12 hours in an air atmosphere to produce a sintered product.

**Comparative Example 4**

A positive electrode active material (lithium-rich manganese-based oxide) powder was obtained by performing the same method as in Example 1 except that 100 g of a raw material powder obtained through pulverizing and mixing was taken and placed in a crucible and sintered at 900°C for 12 hours in an air atmosphere to produce a sintered product.

**Experimental Examples**

**Experimental Example 1: XRD Analysis**

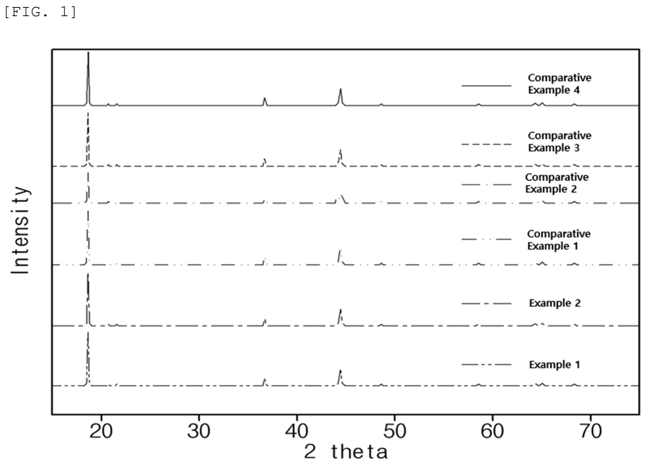

For each of the positive electrode active materials prepared in the Examples and Comparative Examples, XRD measurement was conducted, and XRD data are shown in FIG. 1.

In this case, the XRD (Bruker Co., D8 Endeavor) collected 2 g to 3 g of positive electrode active material particles from each positive electrode active material powder, and measured by an X-ray diffraction analysis method using Cu-K$\alpha$ rays (wavelength 1.54 Å) at an acceleration voltage of 40 kV/40 mA, a scan speed of 0.2°/sec, in a 2$\theta$ range of 15° to 80°.

FIG. 1 illustrates XRD data for the positive electrode active materials prepared in Example 1, Example 2, and Comparative Examples 1 to 4.

Through FIG. 1, it was confirmed that the positive electrode active materials prepared in Example 1, Example 2, and Comparative Examples 1, 3 and 4 contained two phases at the same time. Specifically, it was confirmed that a $Li_2MnO_3$ phase was included as a small peak existing at 20° to 25°, a $LiMO_2$ (where, M is an element including Ni, Mn, or a combination thereof) phase was included as a large peak existing at 18°, and it was confirmed that a $LiMn_2O_4$ phase was not included.

Meanwhile, in a case of Comparative Example 2, that is, the positive electrode active material prepared using a mixing device rather than the pulverizing device equipped with a rotor in FIG. 5, it was confirmed that a $Li_2MnO_3$ phase and a $LiMO_2$ (where M is an element including Ni, Mn or a combination thereof) phase were included at the same time by having peaks similar to those in the Examples at 20° to 25°, and 18°, and it was confirmed that the peak patterns were different from those in the Examples at about 36.5°, about 44.5°, and about 60° to 70° due to non-uniform mixing. Particularly, it was confirmed that a $LiMn_2O_4$ phase was included through split peaks existing at about 44.5°.

In conclusion, it was confirmed that the positive electrode active materials prepared in Example 1, Example 2, and Comparative Example 1, Comparative Example 3, and Comparative Example 4 were lithium-rich manganese-based oxides including a $Li_2MnO_3$ phase and a $LiMO_2$ (where M is an element including at least one selected from Ni, Co and Mn) phase, and the positive electrode active material prepared in Comparative Example 2 included a $LiMn_2O_4$ phase and was not a lithium-rich manganese-based oxide according to the present invention.

**Experimental Example 2: Form, Particle Size and BET Specific Surface Area Analysis**

**-Form**

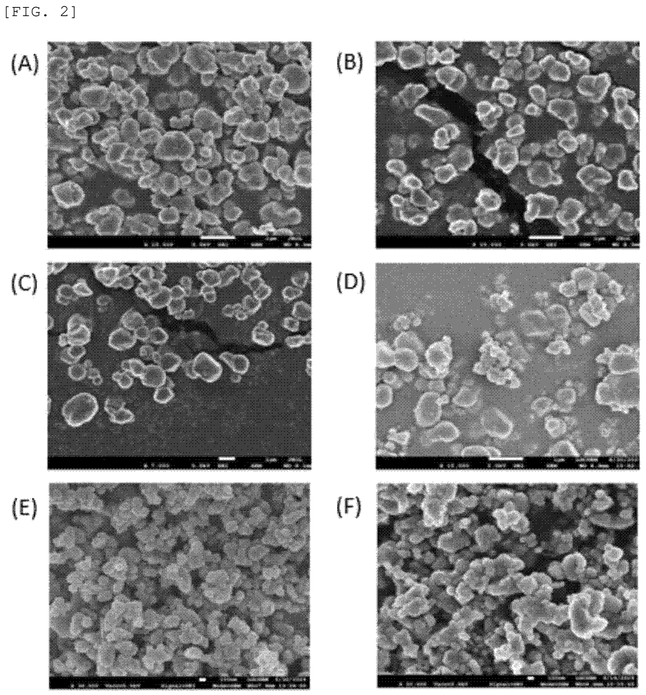

For the positive electrode active materials prepared in the Examples and Comparative Examples, SEM images were obtained using a scanning electron microscope (SEM) (JEOL Co., JSM7610F), and are shown in FIG. 2.

Particularly, FIG. 2(A) illustrates a SEM image of the positive electrode active material prepared in Example 1, FIG. 2(B) illustrates a SEM image of the positive electrode active material prepared in Example 2, FIG. 2(C) illustrates a SEM image of the positive electrode active material prepared in Example 3, FIG. 2(D) illustrates a SEM image of the positive electrode active material prepared in Comparative Example 1, FIG. 2(E) illustrates a SEM image of the positive electrode active material prepared in Comparative Example 3, and FIG. 2(F) illustrates a SEM image of a positive electrode active material prepared in Comparative Example 4.

As shown in FIG. 2, it was confirmed that the positive electrode active materials prepared in Examples 1 to 3 according to the present invention were in the form of single particles.

**- Particle Size**

For each of the positive electrode active material particles prepared in the Examples and Comparative Examples, the minimum particle diameter ($D_{min}$) ($\mu$m), average particle diameter ($D_{50}$) ($\mu$m), and maximum particle diameter ($D_{max}$) ($\mu$m) of the positive electrode active material were measured using PSA (Microtrac Co., S3500), and the results are shown in Table 1 below.

**- BET Specific Surface Area**

The positive electrode active materials prepared in the Examples and Comparative Examples were sintered at 120°C for 6 hours in a vacuum atmosphere to remove all moisture, and then the specific surface area was measured by a BET method by calculating from a nitrogen gas adsorption amount at liquid nitrogen temperature (77K) using BELSORP-mini II of BEL Japan Co., and the results are shown in Table 1 below.

[Table 1]

|  | Minimum particle diameter ($D_{min}$) ($\mu$m) | Average particle diameter ($D_{50}$) ($\mu$m) | Maximum particle diameter ($D_{max}$) ($\mu$m) | BET specific surface area ($m^2$/g) |
|---|---|---|---|---|
| Example 1 | 0.54 | 0.87 | 3.86 | 2.32 |
| Example 2 | 0.62 | 0.94 | 3.97 | 2.24 |
| Example 3 | 0.77 | 1.24 | 4.78 | 1.78 |
| Comparative Example 1 | 0.21 | 0.47 | 2.32 | 3.57 |
| Comparative Example 2 | 0.52 | 0.90 | 4.02 | 2.30 |
| Comparative Example 3 | 0.10 | 0.54 | 5.16 | 5.48 |
| Comparative Example 4 | 0.14 | 0.62 | 5.32 | 4.73 |

Through Table 1 above, it was confirmed that the positive electrode active materials prepared in Example 1 to Example 3 had an average particle diameter ($D_{50}$) of 0.6 $\mu$m to 1.5 $\mu$m. On the other hand, the positive electrode active materials prepared in Comparative Example 1 and Comparative Example 3 had an average particle diameter ($D_{50}$) of less than 0.6 $\mu$m, which was measured to be relatively small compared to the Examples.

In addition, it was confirmed that the positive electrode active materials prepared in Examples 1 to 3 had a BET specific surface area of 1.5 $m^2$/g to 3.0 $m^2$/g. On the other hand, the positive electrode active materials prepared in Comparative Examples 1 to 4 had a BET specific surface area greater than 3.0 $m^2$/g, which was measured to be relatively high compared to the Examples.

In conclusion, it can be found that the positive electrode active material according to the present invention is in the form of single particles, has a small specific surface area, and has improved structural stability.

**Experimental Example 3: Single Crystallinity Analysis**

For each of the positive electrode active materials prepared in the Examples and Comparative Examples, 92.5 wt% of the positive electrode active material, 3.0 wt% of Super P as a conductive material, and 4.5 wt% of polyvinylidene fluoride (PVDF) as a binder were mixed in an N-methylpyrrolidone (NMP) solvent to prepare a positive electrode slurry. The prepared positive electrode slurry was applied to one surface of an aluminum current collector and then dried at 130°C to manufacture a positive electrode for EBSD analysis. Rolling was not performed during the manufacture of the positive electrode.

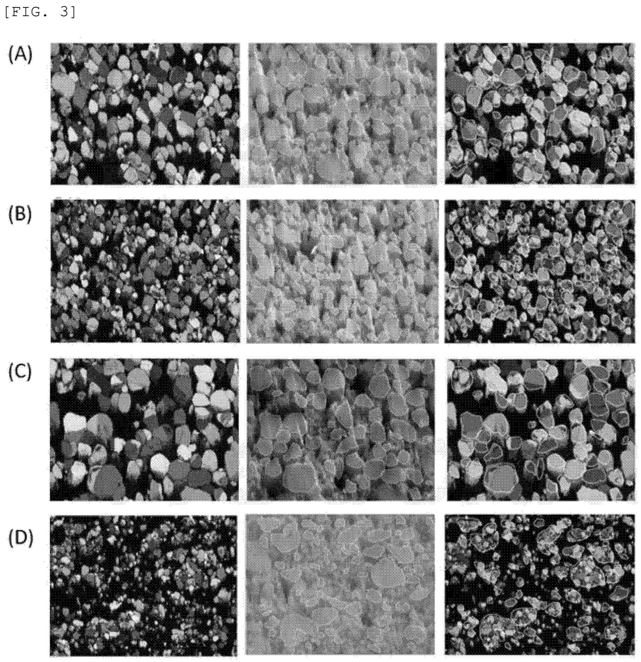

Using an ion milling device (HITACHI IM-500, acceleration voltage 6 kV), the positive electrode was cut into a cross section, and an FE-SEM equipped with an electron backscatter diffraction pattern analyzer (EBSD) (JEOL Co., JSM-7900Fw, Oxford Symmetry EBSD detector) was used to perform EBSD analysis on the cross section of the positive electrode to obtain an IPF map, which is shown in FIG. 3. The EBSD analysis was performed under the conditions of an acceleration voltage of 20 kV and a W.D. of 18 mm.

By performing image processing on the crystal grains identified in the IPF map image using an artificial intelligence model, a two-dimensional segmentation image divided into primary particle units is obtained. The segmentation image may be obtained by performing EBSD analysis on a positive electrode for EBSD analysis, manufactured using a positive electrode active material to be measured to obtain an image, inputting the image into a U-NET structure or the like to generate a boundary image, identifying a plurality of objects included in the boundary image, and then segmenting the IPF map image into primary particle units based on the plurality of objects.

In the present description, the cross-sectional area (A) of a single particle may be measured through the number of pixels corresponding to each of n single particles present in the segmentation image. Specifically, it may be calculated through the number of pixels of the cross-sectional area corresponding to each single particle if the IPF map image is converted into a segmentation image, which is an image projected onto a two-dimensional plane.

In the present description, the cross-sectional area of a crystal grain may be measured through the number of pixels corresponding to each of n crystal grains present in the segmentation image. Specifically, it may be calculated through the number of pixels of the cross-sectional area corresponding to each crystal grain if the IPF map image is converted into a segmentation image, which is an image projected onto a two-dimensional plane.

Specifically, FIG. 3(A) illustrates an IPF map, a boundary image, and a segmentation image obtained by EBSD analysis of the positive electrode for EBSD analysis, manufactured using the positive electrode active material prepared in Example 1, FIG. 3(B) illustrates an IPF map, a boundary image, and a segmentation image obtained by EBSD analysis of the positive electrode for EBSD analysis, manufactured using the positive electrode active material prepared in Example 2, FIG. 3(C) illustrates an IPF map, a boundary image, and a segmentation image obtained by EBSD analysis of the positive electrode for EBSD analysis, manufactured using the positive electrode active material prepared in Example 3, and FIG. 3(D) illustrates an IPF map, a boundary image, and a segmentation image obtained by EBSD analysis of the positive electrode for EBSD analysis, manufactured using the positive electrode active material prepared in Comparative Example 1.

The single crystallinity ($\chi$) calculated by substituting the cross-sectional area of the single particle (A) and the cross-sectional area of the i-th crystal grain (Ai) into Equation 1 explained in the present description is shown in Table 2 below.

[Table 2]

|  | Single crystallinity ($\chi$) |
| --- | --- |
| Example 1 | 0.647 |
| Example 2 | 0.621 |
| Example 3 | 0.676 |
| Comparative Example 1 | 0.509 |

Through Table 2 above, it was confirmed that the single crystallinity ($\chi$) according to Equation 1 explained in the present description was 0.51 to 0.70 for the positive electrode active materials prepared in Examples 1 to 3. On the other hand, it was confirmed that the single crystallinity according to Equation 1 explained in the present description was less than 0.51 for the positive electrode active material prepared in Comparative Example 1.

Meanwhile, in a case of the positive electrode active material prepared in Comparative Example 2, since a $LiMn_2O_4$ phase was formed, it was not a lithium-rich manganese-based oxide according to the present invention, and therefore, the single crystallinity was not additionally calculated. In addition, in a case of the positive electrode active materials prepared in Comparative Examples 3 and 4, it was confirmed that it was difficult to derive the single crystallinity because almost all the particles existed in an agglomerated form.

**Experimental Example 4: Battery Properties Analysis**

**- Manufacture of Coin-type Half Cells**

92.5 wt% of each of the positive electrode active materials prepared in the Examples and Comparative Examples, 3.0 wt% of Super P as a conductive material, and 4.5 wt% of polyvinylidene fluoride (PVDF) as a binder were mixed in an N-methylpyrrolidone (NMP) solvent to prepare a positive electrode slurry. The positive electrode slurry was applied to one surface of an aluminum current collector, dried at 130°C, and then rolled to prepare a positive electrode.

An electrode assembly was manufactured by using a lithium metal electrode as a negative electrode and interposing a porous polyethylene separator between the positive electrode and the negative electrode. The electrode assembly was placed inside a battery case and an electrolyte solution in which 1 M $LiPF_6$ was dissolved in an organic solvent of a mixture of ethylene carbonate (EC):ethyl methyl carbonate (EMC):diethyl carbonate (DEC) in a volume ratio of 3:4:3 was injected to manufacture a coin-type half cell.

**- Positive Electrode Defect Occurrence Evaluation**

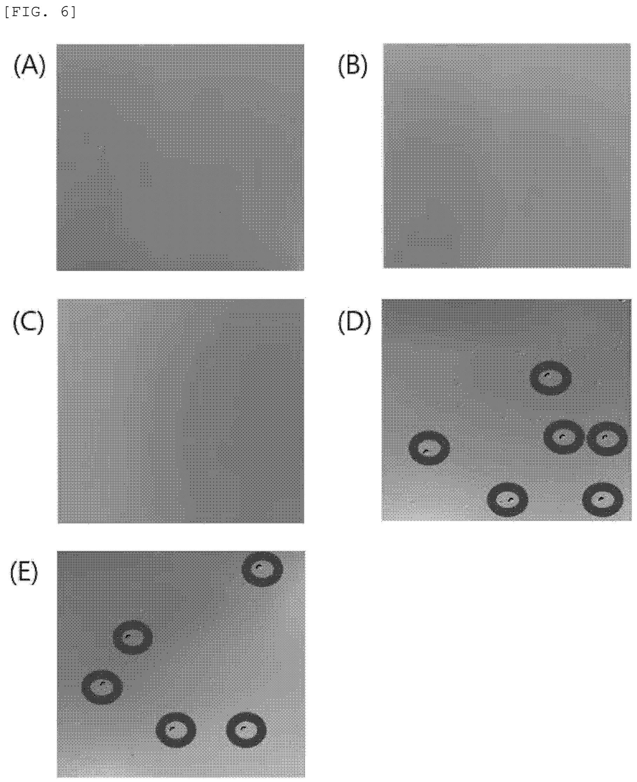

For the positive electrodes including the positive electrode active materials prepared in the Examples and Comparative Examples, the surfaces of the positive electrodes were photographed using a camera, and the images of the surfaces of the positive electrodes including the positive electrode active materials prepared in Examples 1 to 3 and Comparative Examples 3 and 4 are shown in FIG. 6.

Specifically, FIG. 6(A) illustrates an image of the surface of the positive electrode including the positive electrode active material prepared in Example 1, FIG. 6(B) illustrates an image of the surface of the positive electrode including the positive electrode active material prepared in Example 2, FIG. 6(C) illustrates an image of the surface of the positive electrode including the positive electrode active material prepared in Example 3, FIG. 6(D) illustrates an image of the surface of the positive electrode including the positive electrode active material prepared in Comparative Example 3, and FIG. 6(E) illustrates an image of the surface of the positive electrode including the positive electrode active material prepared in Comparative Example 4.

Through FIG. 6, it was confirmed that the surfaces of the positive electrodes including the positive electrode active materials prepared in Examples 1 to 3 had no lumped parts and the surfaces were even. On the other hand, it was confirmed that the surfaces of the positive electrodes including the positive electrode active materials prepared in Comparative Examples 3 and 4 had many lumped parts (indicated by circles) corresponding to defects, and the surfaces were uneven.

**- Battery Properties Evaluation**

The coin-type half cells including the positive electrode active materials prepared in the Examples and Comparative Examples, were charged (0.1 C) in the CC-CV manner at 45°C to 4.65 V, then discharged (0.1 C) in the CC manner to 2.0 V to perform an activation process (formation), and the charge and discharge capacities in this case were measured. The measured charge and discharge capacities, and the percentage of discharge capacity to charge capacity (efficiency (%)) are shown in Table 3 below.

Then, initial charge/discharge processes were performed by charging (0.1 C) to 4.4 V at 25°C in the CC-CV manner, and then discharging (0.1 C) to 2.5 V in the CC manner, and the charge and discharge capacities in this case were measured. The measured charge and discharge capacities, and the percentage of discharge capacity to charge capacity (efficiency (%)) are shown in Table 3 below.

After charging (0.33 C) to 4.4 V at 25°C in the CC-CV manner, initial charge/discharge processes were performed by discharging (0.33 C) to 2.5 V in the CC manner, and the charge and discharge capacities in this case were measured. The measured charge and discharge capacities, and the percentage of discharge capacity to charge capacity (efficiency (%)) are shown in Table 3 below.

The cycle of charging (0.33 C) to 4.4 V at 25°C in the CC-CV manner, and then discharging (0.33 C) to 2.5 V in the CC manner was set as 1 cycle, and total 30 cycles of charging and discharging were repeated, and the discharge capacities in the first and 30th cycles were measured. The measured discharge capacity of the first cycle, and the percentage of the discharge capacity of the 30th cycle to the discharge capacity of the first cycle (capacity retention (%)) are shown in Table 3 below.

[Table 3]

| Divisio n | Formation @45°C/4.65V/0.1C | | | Initial charge and discharge @4.4V/0.1C | | | Initial charge and discharge @ 4.4V/0.33C | | | 30th cycle |
|---|---|---|---|---|---|---|---|---|---|---|
| | Charge capaci ty (mAh/g ) | Disch arge capac ity (mAh/ g) | Effici ency (%) | Charg e capac ity (mAh/ g) | Discha rge capaci ty (mAh/g ) | Effic iency (%) | Charge capaci ty (mAh/g ) | Discha rge capaci ty (mAh/g ) | Effic iency (%) | Capac ity reten tion |
| Example 1 | 314.2 | 275.0 | 87.5 | 222.5 | 202.2 | 90.9 | 199.9 | 185.1 | 92.6 | 99.3 |
| Example 2 | 310.1 | 270.7 | 87.3 | 223.4 | 203.4 | 91.0 | 198.9 | 184.4 | 92.7 | 99.4 |
| Example 3 | 311.1 | 270.5 | 86.9 | 219.7 | 200.8 | 91.4 | 198.1 | 180.4 | 91.1 | 99.6 |
| Compara tive Example 1 | 315.3 | 267.6 | 84.9 | 213.4 | 193.7 | 90.8 | 194.1 | 178.0 | 91.7 | 98.5 |

(continued)

| Divisio n | Formation @45°C/4.65V/0.1C | | | Initial charge and discharge @4.4V/0.1C | | | Initial charge and discharge @ 4.4V/0.33C | | | 30th cycle |
|---|---|---|---|---|---|---|---|---|---|---|
| | Charge capaci ty (mAh/g ) | Disch arge capac ity (mAh/ g) | Effici ency (%) | Charg e capac ity (mAh/ g) | Discha rge capaci ty (mAh/g ) | Effic iency (%) | Charge capaci ty (mAh/g ) | Discha rge capaci ty (mAh/g ) | Effic iency (%) | Capac ity reten tion |
| Compara tive Ex- ample 2 | 308.2 | 255.4 | 82.8 | 202.4 | 179.2 | 88.5 | 181.8 | 161.5 | 88.8 | 96.5 |

Through Table 3 above, it was confirmed that the batteries including the positive electrode active materials prepared in Examples 1 to 3, in which raw materials were mixed using the pulverizing device equipped with a rotor in FIG. 5, were superior to the battery including the positive electrode active material prepared in Comparative Example 1, in which the pulverizing device equipped with a rotor in FIG. 5 was not used and a precursor was mixed, and the battery including the positive electrode active material prepared in Comparative Example 2, in which the pulverizing device equipped with a rotor in FIG. 5 was not used, in terms of discharge capacity and efficiency in the formation, initial charge/discharge capacity and efficiency at 0.1C conditions, initial charge/discharge capacity and efficiency at 0.33C conditions, and capacity retention. Meanwhile, the positive electrode active materials prepared in Comparative Examples 3 and 4, which were sintered at a sintering temperature of 900°C or lower, had high incidence of electrode defects due to a small particle size and a high specific surface area, making it impossible to manufacture a battery.

In conclusion, it can be found that the positive electrode active material according to the present invention has improved structural stability, and accordingly, less irreversible capacity loss occurs during a formation, and structural change is not significant during performing charge/discharge cycles.

**Claims**

1.   A positive electrode active material comprising:

a lithium-rich manganese-based oxide comprising a $Li_2MnO_3$ phase and a $LiMO_2$ (where M is an element comprising one or more selected from Ni, Co and Mn) phase,
wherein the lithium-rich manganese-based oxide has a single particle form, and
the lithium-rich manganese-based oxide has a single crystallinity ($\chi$) of 0.51 to 0.70 according to the following Equation 1:

$$[\text{Equation 1}]$$

$$\chi = \sum_i a_i^2$$

in Equation 1,
$a_i$ means a value ($A_i/A$) of a cross-sectional area ($A_i$) of an i-th crystal grain relative to a cross-sectional area (A) of a single particle in a case where the single particle is composed of i crystal grains.

2.   The positive electrode active material according to claim 1, wherein the lithium-rich manganese-based oxide is represented by the following Formula 1:

[Formula 1]          $Li_xNi_aMn_bM^1_cO_2$

in Formula 1,

$M^1$ is one or more selected from the group consisting of Co, Al, Zr, B, W, Mo, Cr, Nb, Mg, Hf, Ta, La, Ti, Sr, Ba, Ce, Sn, Y and Zn,
$1.00 < x \leq 1.30$, $0.10 \leq a \leq 0.50$, $0.50 \leq b \leq 0.90$, $0 \leq c \leq 0.10$, and $x+a+b+c = 2$.

3. The positive electrode active material according to claim 1, wherein an average particle diameter ($D_{50}$) of the lithium-rich manganese-based oxide is $0.6 \mu m$ to $1.5 \mu m$.

4. The positive electrode active material according to claim 1, wherein a BET specific surface area of the lithium-rich manganese-based oxide is $1.5 \, m^2/g$ to $3.0 \, m^2/g$.

5. The positive electrode active material according to claim 1, further comprising a coating layer that is formed on the lithium-rich manganese-based oxide and comprises one or more coating elements selected from the group consisting of Al, Ti, W, B, F, P, Mg, Ni, Co, Fe, Cr, V, Cu, Ca, Zn, Zr, Nb, Sr, Sb, Bi, Si and S.

6. A method for preparing the positive electrode active material according to claim 1, the method comprising:

   (S10) a step of injecting a lithium (Li)-containing raw material, a nickel (Ni)-containing raw material and a manganese (Mn)-containing raw material to a pulverizing device, dry mixing and pulverizing to prepare a mixture;
   (S20) a step of sintering the mixture at a temperature of greater than 900°C to 1,100°C or less to prepare a sintered product; and
   (S30) a step of disintegrating the sintered product to obtain a positive electrode active material comprising a lithium-rich manganese-based oxide,
   wherein the pulverizing device comprises a chamber and a rotor rotatable within the chamber, and
   the mixing and pulverizing in step (S10) is performed by injecting the lithium (Li)-containing raw material, the nickel (Ni)-containing raw material, the manganese (Mn)-containing raw material, and beads to the chamber of the pulverizing device and rotating the rotor.

7. The method for preparing the positive electrode active material according to claim 6, wherein the sintering in step (S20) is performed for 6 hours to 15 hours.

8. The method for preparing the positive electrode active material according to claim 6, further comprising:

   after disintegrating the sintered product in step (S30), a step of mixing the lithium-rich manganese-based oxide and a coating raw material and heating to form a coating layer on the lithium-rich manganese-based oxide, wherein the heating is performed under a temperature of 300°C to 600°C.

9. A positive electrode comprising the positive electrode active material according to any one of claims 1 to 5.

10. A lithium secondary battery comprising the positive electrode according to claim 9.

[FIG. 1]

[FIG. 2]

[FIG. 3]

[FIG. 4]

[FIG. 5]

[FIG. 6]

(A)

(B)

(C)

(D)

(E)

# INTERNATIONAL SEARCH REPORT

| | International application No. |
|---|---|
| | **PCT/KR2024/010876** |

### A. CLASSIFICATION OF SUBJECT MATTER

**H01M 4/505**(2010.01)i; **H01M 4/36**(2006.01)i; **C30B 29/22**(2006.01)i; **C01G 53/00**(2006.01)i; **H01M 10/052**(2010.01)i; **H01M 4/131**(2010.01)i; **H01M 4/1391**(2010.01)i; **H01M 4/02**(2006.01)i

According to International Patent Classification (IPC) or to both national classification and IPC

### B. FIELDS SEARCHED

Minimum documentation searched (classification system followed by classification symbols)

H01M 4/505(2010.01); H01M 10/052(2010.01); H01M 4/131(2010.01); H01M 4/525(2010.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 리튬(lithium), 이차전지(secondary battery), 단입자(single particle), 결정립(grain), 단면(section)

### C. DOCUMENTS CONSIDERED TO BE RELEVANT

| Category* | Citation of document, with indication, where appropriate, of the relevant passages | Relevant to claim No. |
|---|---|---|
| A | KR 10-2014-0025793 A (KOREA INSTITUTE OF SCIENCE AND TECHNOLOGY) 05 March 2014 (2014-03-05)<br>See claims 1-3 and 5-8. | 1-10 |
| A | KR 10-2467486 B1 (TOP MATERIAL CO., LTD.) 17 November 2022 (2022-11-17)<br>See paragraphs [0114]-[0123]; and claims 1, 7-12 and 19-20. | 1-10 |
| A | KR 10-2019-0059241 A (LG CHEM, LTD.) 30 May 2019 (2019-05-30)<br>See claims 1-16. | 1-10 |
| A | KR 10-2022-0097196 A (ECOPRO BM CO., LTD.) 07 July 2022 (2022-07-07)<br>See paragraphs [0026]-[0032]; and claims 6 and 10-12. | 1-10 |
| A | KR 10-2019-0038314 A (LG CHEM, LTD.) 08 April 2019 (2019-04-08)<br>See claims 1, 4 and 8-10. | 1-10 |

☐ Further documents are listed in the continuation of Box C.　　☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | "&" document member of the same patent family |
| "P" document published prior to the international filing date but later than the priority date claimed | |

| Date of the actual completion of the international search | Date of mailing of the international search report |
|---|---|
| **04 November 2024** | **04 November 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2024/010876**

| Patent document cited in search report | | | Publication date (day/month/year) | Patent family member(s) | | | Publication date (day/month/year) |
|---|---|---|---|---|---|---|---|
| KR | 10-2014-0025793 | A | 05 March 2014 | KR | 10-1449558 | B1 | 13 October 2014 |
| | | | | US | 2014-0057175 | A1 | 27 February 2014 |
| KR | 10-2467486 | B1 | 17 November 2022 | None | | | |
| KR | 10-2019-0059241 | A | 30 May 2019 | CN | 111164806 | A | 15 May 2020 |
| | | | | CN | 111164806 | B | 21 April 2023 |
| | | | | CN | 116154148 | A | 23 May 2023 |
| | | | | EP | 3680968 | A1 | 15 July 2020 |
| | | | | EP | 4250404 | A2 | 27 September 2023 |
| | | | | EP | 4250404 | A3 | 06 December 2023 |
| | | | | JP | 2020-520539 | A | 09 July 2020 |
| | | | | JP | 6929588 | B2 | 01 September 2021 |
| | | | | KR | 10-2023-0153983 | A | 07 November 2023 |
| | | | | KR | 10-2656223 | B1 | 11 April 2024 |
| | | | | KR | 10-2687546 | B1 | 24 July 2024 |
| | | | | US | 11594727 | B2 | 28 February 2023 |
| | | | | US | 11909045 | B2 | 20 February 2024 |
| | | | | US | 11967714 | B2 | 23 April 2024 |
| | | | | US | 2020-0295367 | A1 | 17 September 2020 |
| | | | | US | 2023-0163295 | A1 | 25 May 2023 |
| | | | | US | 2023-0352678 | A1 | 02 November 2023 |
| | | | | US | 2024-0234719 | A1 | 11 July 2024 |
| | | | | WO | 2019-103458 | A1 | 31 May 2019 |
| KR | 10-2022-0097196 | A | 07 July 2022 | CN | 116325218 | A | 23 June 2023 |
| | | | | EP | 4220773 | A1 | 02 August 2023 |
| | | | | JP | 2023-546101 | A | 01 November 2023 |
| | | | | US | 2023-0238530 | A1 | 27 July 2023 |
| | | | | WO | 2022-145693 | A1 | 07 July 2022 |
| KR | 10-2019-0038314 | A | 08 April 2019 | CN | 110383542 | A | 25 October 2019 |
| | | | | CN | 110383542 | B | 14 June 2022 |
| | | | | EP | 3576193 | A2 | 04 December 2019 |
| | | | | EP | 3576193 | B1 | 02 November 2022 |
| | | | | JP | 07-041803 | B2 | 25 March 2022 |
| | | | | JP | 2020-511741 | A | 16 April 2020 |
| | | | | KR | 10-2498342 | B1 | 10 February 2023 |
| | | | | US | 11289695 | B2 | 29 March 2022 |
| | | | | US | 2019-0386294 | A1 | 19 December 2019 |
| | | | | WO | 2019-066297 | A2 | 04 April 2019 |
| | | | | WO | 2019-066297 | A3 | 23 May 2019 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230100308
- KR 1020160080865